# EUROPÄISCHE PATENTSCHRIFT

(11) **EP 3 388 845 B1**
(45) Veröffentlichungstag und Bekanntmachung des Hinweises auf die Patenterteilung: **01.06.2022**
(21) Anmeldenummer: 18162910.6
(22) Anmeldetag: 20.03.2018
(51) Int. Cl.: G01R 15/06, G01R 19/165, G01R 19/30, G01R 19/04

(54) **SCHALTANORDNUNG ZUR MESSUNG EINER NETZSPANNUNG**
SWITCHING DEVICE FOR THE MEASURING OF MAINS VOLTAGE
DISPOSITIF DE COMMUTATION PERMETTANT DE MESURER UNE TENSION RÉSEAU

(30) Priorität: 10.04.2017 DE 102017206101
(43) Veröffentlichungstag der Anmeldung: 17.10.2018
(73) Patentinhaber: BSH Hausgeräte GmbH, 81739 München (DE)
(72) Erfinder: Boehm, Burkhard, 64401 Groß-Bieberau (DE)

(56) Entgegenhaltungen:
- US-A1- 2006 267 413
- US-B1- 6 348 798

## Beschreibung

Die Erfindung betrifft eine Schaltanordnung zur Messung der Netzspannung, insbesondere zur Messung der Netzspannung in einem Hausgerät.

Die durch ein Energieversorgungsnetz bereitgestellte Netzspannung kann mit der Zeit variieren. Beispielsweise kann die in einem 230VAC-Versorgungsnetz bereitgestellte Netzspannung zwischen 130VAC und 300VAC schwanken.

Elektrische Geräte, insbesondere Hausgeräte, können darauf ausgelegt sein, mit einer Netzspannung in einem bestimmten Netzspannungsbereich betrieben zu werden. Der zulässige Netzspannungsbereich ist dabei durch eine untere Netzspannungsschwelle und eine obere Netzspannungsschwelle begrenzt. Ein Unterschreiten der unteren Netzspannungsschwelle und/oder ein Überschreiten der oberen Netzspannungsschwelle können zu einer Fehlfunktion des elektrischen Geräts oder zu einer Schädigung einer Komponente des elektrischen Geräts führen.

Relevanter Stand der Technik findet sich in den Dokumenten US2006/267413 und US6348798.

Das vorliegende Dokument befasst sich mit der technischen Aufgabe, eine Schaltanordnung bereitzustellen, durch die in präziser und effizienter Weise die einem elektrischen Gerät bereitgestellte Netzspannung überwacht werden kann.

Die Aufgabe wird durch den Gegenstand des unabhängigen Patentanspruchs gelöst. Vorteilhafte Ausführungsformen sind insbesondere in den abhängigen Patentansprüchen definiert, in nachfolgender Beschreibung beschrieben oder in den beigefügten Zeichnungen dargestellt.

Gemäß einem Aspekt der Erfindung wird eine Schaltanordnung (bzw. eine Schaltung) zur Ermittlung von Messdaten in Bezug auf eine Netzspannung eines elektrischen Geräts beschrieben. Die Netzspannung ist typischerweise eine Wechselspannung, die über ein Versorgungsnetz bereitgestellt wird. Beispielsweise kann eine 230V Wechselspannung mit einer 50Hz Netzfrequenz oder eine 130V Wechselspannung mit einer 60Hz Netzfrequenz bereitgestellt werden. Die Netzspannung kann dazu verwendet werden, ein elektrisches Gerät, insbesondere ein Hausgerät bzw. ein Haushaltsgerät (etwa eine Spülmaschine, eine Waschmaschine, einen Kühlschrank, einen Wäschetrockner, etc.) zu betreiben.

Die Schaltanordnung umfasst einen Konvertierungs-Transistor und einen Referenz-Widerstand, die in Reihe zwischen der Netzspannung (z.B. einem Neutralleiter bzw. einem Phasenleiter des Versorgungsnetzes) und einem Referenz-Potential (z.B. Masse bzw. Ground) angeordnet sind. Dabei kann der Konvertierungs-Transistor einen Bipolartransistor, insbesondere einen NPN Hochspannungs-Bipolartransistor (für Spannungen im Bereich der Netzspannung), umfassen. Der Kollektor des Konvertierungs-Transistors kann (ggf. über eine Diode und/oder über ein oder mehrere Widerstände) mit der Netzspannung gekoppelt sein. Der Emitter des Konvertierungs-Transistors kann mit dem Referenz-Transistor gekoppelt sein und der Referenz-Transistor kann mit dem Referenz-Potential gekoppelt sein.

Der Konvertierungs-Transistor und der Referenz-Transistor können somit derart in Reihe geschaltet sein, dass an einem Messpunkt zwischen dem Konvertierungs-Transistor und dem Referenz-Transistor eine von der Netzspannung abhängige Messspannung bereitgestellt wird, wenn der Konvertierungs-Transistor zumindest teilweise geschlossen ist. Der Messpunkt kann dabei dem Emitter des Konvertierungs-Transistors entsprechen. Der Konvertierungs-Transistor kann einen bestimmten Durchlass-Widerstand aufweisen, so dass der Durchlass-Widerstand und der Referenz-Widerstand einen Spannungsteiler bilden. Die Messspannung an dem Messpunkt kann somit proportional zu der Netzspannung sein. Dabei kann der Proportionalitätsfaktor von den Widerstandswerten des Referenz-Widerstands und des Durchlass-Widerstands des Konvertierungs-Transistors abhängen. Der Proportionalitätsfaktor kann im Vorfeld bestimmt werden (durch Messung und/oder durch Design der Schaltanordnung), so dass aus dem Wert der Messspannung in präziser Weise der Wert der Netzspannung ermittelt werden kann.

Außerdem umfasst die Schaltanordnung eine Steuereinheit (z.B. einen Mikrocontroller) mit zumindest einem Messeingang. Der Messeingang kann z.B. einen Analog-Digital Wandler umfassen, der eingerichtet ist, einen analogen Spannungswert in digitale Messdaten zu überführen. Der Messeingang kann einen bestimmten Messspannungsbereich aufweisen, in dem analoge Spannungswerte in digitale Messdaten überführt werden. Der Messbereich kann z.B. zwischen 0V und 5V liegen.

Der zumindest eine Messeingang ist (direkt und/oder indirekt) mit dem Messpunkt gekoppelt, so dass durch die Steuereinheit Messdaten in Bezug auf die Messspannung erfasst werden können. Der Konvertierungs-Transistor kann somit dazu genutzt werden, die Netzspannung aus einem Netzspannungsbereich (von z.B. 0V bis 230V bzw. 0V bis 130V) in eine Messspannung in einem Messspannungsbereich (von z.B. 0V bis 5V) zu übersetzen (bevorzugt in proportionaler Weise). Die Messspannung kann dann in effizienter Weise durch die ein oder mehreren Messeingänge einer (digitalen) Steuereinheit erfasst werden. So wird eine effiziente und präzise Messung einer Netzspannung ermöglicht.

Die Steuereinheit kann eingerichtet sein, auf Basis der Messdaten einen Messzeitraum zur Messung von Messdaten in Bezug auf einen Scheitelpunkt der Netzspannung zu bestimmen. Insbesondere kann auf Basis der Messdaten der Messzeitraum derart (innerhalb einer Periode der Netzspannung) positioniert werden, dass sich der Scheitelpunkt der Netzspannung innerhalb des Messzeitraums befindet. Der Messzeitraum kann dabei nur einen Bruchteil der Periodendauer einer Periode der Netzspannung aufweisen. Insbesondere kann der Messzeitraum eine Zeitdauer aufweisen, die 20%, 15%, 10% oder weniger der Periodendauer der Netzspannung entspricht. Durch eine zeitliche Begrenzung des Messzeitraums auf einen Bruchteil der Periodendauer kann eine präzise Messung des Spannungswertes des Scheitelpunktes der Netzspannung ermöglicht werden (auch wenn die ein oder mehreren Messeingänge der Steuereinheit eine relativ geringe Abtastrate bzw. relativ geringe zeitliche Auflösung der digitalen Messdaten ermöglichen).

Zur Erfassung von Messdaten in Bezug auf den Scheitelpunkt der Netzspannung kann die Steuereinheit eingerichtet sein, den Konvertierungs-Transistor in Abhängigkeit von dem Messzeitraum anzusteuern. Insbesondere kann der Konvertierungs-Transistor (zumindest) für die Dauer des Messzeitraums infolge einer Ansteuerung der Steuereinheit geschlossen werden, so dass an dem Messpunkt eine von der Netzspannung abhängige Messspannung anliegt, die dann über die ein oder mehreren Messeingänge der Steuereinheit erfasst werden kann. Es wird somit in effizienter und zuverlässiger Weise eine präzise Ermittlung der Maximalspannung (d.h. des Spannungswertes des Scheitelpunktes) der Netzspannung ermöglicht.

Die Steuereinheit kann weiter eingerichtet sein, das elektrische Gerät in Abhängigkeit von den Messdaten in Bezug auf den Scheitelpunkt der Netzspannung anzusteuern. Insbesondere kann ermittelt werden, ob der Scheitelpunkt der Netzspannung über einem oberen Netzspannungsschwellenwert bzw. unter einem unteren Netzspannungsschwellenwert liegt. Wenn dies der Fall ist, so kann veranlasst werden, dass das elektrische Gerät in einen sicheren Zustand überführt wird (z.B. in einen Ruhemodus), um eine Fehlfunktion des elektrischen Geräts zu vermeiden und/oder um eine Schädigung einer Komponente des elektrischen Geräts zu vermeiden.

Wie bereits oben dargelegt, weist die Netzspannung typischerweise eine Netzfrequenz auf. Die Steuereinheit kann eingerichtet sein, Messzeiträume zur Erfassung von Messdaten in Bezug auf den Scheitelpunkt der Netzspannung in Abhängigkeit von der Netzfrequenz zu wiederholen. Insbesondere kann in jeder bzw. in jeder Q^{ten} (Q=2, 3, 4 oder mehr) Periode der Netzspannung ein Messzeitraum zur Erfassung von Messdaten in Bezug auf den Scheitelpunkt der Netzspannung positioniert werden. So kann die Netzspannung in kontinuierlicher Weise überwacht werden.

Die Schaltanordnung kann einen Mess-Widerstand und einen Mess-Transistor umfassen, die in Reihe zwischen dem Messpunkt und dem Referenz-Potential angeordnet sind. Dabei kann die erste Seite des Mess-Widerstands mit dem Messpunkt gekoppelt sein. Des Weiteren kann die zweite Seite des Mess-Widerstands mit dem Mess-Transistor gekoppelt sein. Durch Schließen des Mess-Transistors (der z.B. einen Feldeffekttransistor und/oder einen Metalloxid Halbleiter, MOS, Transistor umfasst) kann somit der Mess-Widerstand parallel zu dem Referenz-Widerstand angeordnet werden, so dass der Proportionalitätsfaktor zwischen der Messspannung und der Netzspannung auch von dem Widerstandswert des Mess-Widerstands und von dem Widerstandswert des Durchlass-Widerstands des Mess-Transistors abhängt (und im Vorfeld ermittelt werden kann).

Die Steuereinheit kann einen ersten Messeingang (mit einem ersten Analog-Digital Wandler) aufweisen, der mit der ersten Seite des Mess-Widerstands gekoppelt ist. Des Weiteren kann die Steuereinheit einen zweiten Messeingang (mit einem zweiten Analog-Digital Wandler) umfassen, der mit der zweiten Seite des Mess-Widerstands gekoppelt ist. Es kann somit über die beiden Messeingänge in präziser Weise ein Spannungsabfall an dem Mess-Widerstand erfasst werden, was eine präzise Erfassung von Messdaten in Bezug auf die Netzspannung ermöglicht.

Der Messpunkt kann über zumindest einen Tiefpassfilter, insbesondere über zumindest ein RC-Glied, mit dem zumindest einen Messeingang der Steuereinheit gekoppelt sein. Insbesondere kann die erste Seite des Mess-Widerstands (die direkt mit dem Messpunkt gekoppelt sein kann) über einen ersten Tiefpassfilter, insbesondere über ein erstes RC-Glied, mit dem ersten Messeingang gekoppelt sein. Des Weiteren kann die zweite Seite des Mess-Widerstands über einen zweiten Tiefpassfilter, insbesondere über ein zweites RC-Glied, mit dem zweiten Messeingang gekoppelt sein. So kann die Genauigkeit der Spannungsmessung weiter erhöht werden. Insbesondere können so Störungen und/oder Rauschen bei der Spannungsmessung reduziert werden.

Die Steuereinheit kann eingerichtet sein, den Mess-Transistor bereits vor einem Beginn des Messzeitraums zu schließen (z.B. vor einem Schließzeitpunkt des Konvertierungs-Transistors). So können der Messpunkt und/oder der zumindest eine Messeingang durch Kopplung mit dem Referenz-Potential (für eine nachfolgende Messung) in einen definierten Zustand überführt werden. Insbesondere können so Mess-Kondensatoren der ein oder mehreren RC-Glieder in Vorbereitung auf eine nachfolgende Messung entladen werden. So kann die Qualität der Spannungsmessung weiter erhöht werden.

Des Weiteren kann die Steuereinheit eingerichtet sein, den Mess-Transistor am Ende des Messzeitraums zu öffnen. Dabei kann der Konvertierungs-Transistor ggf. auch am Ende des Messzeitraums geschlossen bleiben. Durch das Schließen des Mess-Transistors am Ende des Messzeitraums kann der Messzeitraum in präziser Weise beendet werden, was wiederum eine erhöhte Genauigkeit der Spannungsmessung ermöglicht (insbesondere der Messung des Spannungswertes des Scheitelwertes der Netzspannung).

Die Schaltanordnung kann zumindest eine Diode (insbesondere eine Schottky-Diode) umfassen, die in Reihe mit dem Konvertierungs-Transistor und dem Referenz-Transistor zwischen der Netzspannung und dem Referenz-Potential angeordnet ist, so dass an dem Konvertierungs-Transistor jeweils nur Halbwellen der Netzspannung mit einer ersten Polarität relativ zu dem Referenz-Potential (z.B. nur positive Halbwellen) anliegen. Die Diode kann insbesondere zwischen der Netzspannung und dem Kollektor des Konvertierungs-Transistors angeordnet sein. Durch die Gleichrichtung der Netzspannung kann die Erfassung von Messdaten vereinfacht werden (da der erforderliche Messspannungsbereich reduziert, insbesondere halbiert, werden kann).

Die Schaltanordnung kann Mittel, insbesondere eine Zener-Diode, umfassen, um die Messspannung an dem Messpunkt auf einen bestimmten Maximalwert (z.B. 5V) zu begrenzen. So können die ein oder mehreren Messeingänge der Steuereinheit in zuverlässiger Weise vor außergewöhnlichen Überhöhungen der Netzspannung geschützt werden.

Die Schaltanordnung kann einen ersten Treiber-Transistor (z.B. einen MOSFET) umfassen, der angeordnet ist, einen Kontrollport (z.B. eine Basis) des Konvertierungs-Transistors über einen ersten Treiber-Widerstand mit einer Schaltspannung (z.B. mit einer 12V Spannungsquelle) zu koppeln. Beispielsweise können der erste Treiber-Widerstand und der erste Treiber-Transistor in Reihe zwischen der Schaltspannung und dem Referenz-Potential angeordnet sein. Der Mittelpunkt zwischen dem ersten Treiber-Widerstand und dem ersten Treiber-Transistor kann dann mit dem Kontrollport gekoppelt sein. Durch Öffnen des ersten Treiber-Transistors kann der Kontrollport über den ersten Treiber-Transistor mit der Schaltspannung gekoppelt werden.

Des Weiteren kann die Schaltanordnung einen zweiten Treiber-Transistor (z.B. einen MOSFET) umfassen, der angeordnet ist, den Kontrollport des Konvertierungs-Transistors über einen zweiten Treiber-Widerstand mit der Schaltspannung zu koppeln. Beispielsweise können der zweite Treiber-Widerstand und der zweite Treiber-Transistor in Reihe zwischen der Schaltspannung und dem Referenz-Potential angeordnet sein. Der Mittelpunkt zwischen dem zweiten Treiber-Widerstand und dem zweiten Treiber-Transistor kann mit dem Kontrollport gekoppelt sein. Durch Öffnen des zweiten Treiber-Transistors kann der Kontrollport über den zweiten Treiber-Transistor mit der Schaltspannung gekoppelt werden.

Die Steuereinheit kann eingerichtet sein, den ersten Treiber-Transistor und/oder den zweiten Treiber-Transistor anzusteuern, um den Konvertierungs-Transistor zu schließen und/oder geschlossen zu halten bzw. um den Konvertierungs-Transistor zu öffnen. Durch die Bereitstellung von mehreren Treiber-Schaltungen (insbesondere mehreren Treiber-Transistoren und mehreren Treiber-Widerständen) für die Steuerung des Konvertierungs-Transistors können gleichzeitig die Schaltgeschwindigkeit und die Energieeffizienz der Steuerung des Konvertierungs-Transistors optimiert werden.

Beispielsweise kann der erste Treiber-Widerstand einen kleineren Widerstandswert aufweisen als der zweite Treiber-Widerstand. Des Weiteren kann der erste Treiber-Transistor derart angeordnet sein, dass über den ersten Treiber-Transistor der Kontrollport des Konvertierungs-Transistors über eine Sperr-Diode mit dem Referenz-Potential gekoppelt werden kann, wobei die Sperr-Diode in einer Richtung von dem Kontrollport zum Referenz-Potential sperrt. Mit anderen Worten, der Mittelpunkt zwischen dem ersten Treiber-Widerstand und dem ersten Treiber-Transistor kann über eine Sperr-Diode mit dem Kontrollport gekoppelt sein, wobei die Sperr-Diode eingerichtet ist, einen von dem Kontrollport wegfließenden Strom zu blockieren.

Die Steuereinheit kann eingerichtet sein, zu Beginn des Messzeitraums (zumindest) den ersten Treiber-Transistor anzusteuern, um den Konvertierungs-Transistor zu schließen. Insbesondere kann (zumindest) der erste Treiber-Transistor angesteuert werden, um den Kontrollport über den ersten Treiber-Widerstand mit der Schaltspannung zu koppeln. Als Folge daraus kann ein relativ hoher Strom über den ersten Treiber-Widerstand zum Kontrollport des Konvertierungs-Transistors fließen, was ein schnelles Schließen des Konvertierungs-Transistors und somit einen präzisen Beginn des Messzeitraums ermöglicht.

Die Steuereinheit kann weiter eingerichtet sein, nach Schließen des Konvertierungs-Transistors und ggf. nach Ende des Messzeitraums den zweiten Treiber-Transistor anzusteuern, um den Konvertierungs-Transistor geschlossen zu halten. Des Weiteren kann die Steuereinheit eingerichtet sein, nach Schließen des Konvertierungs-Transistors und ggf. nach Ende des Messzeitraums den ersten Treiber-Transistor anzusteuern, den Kontrollport des Konvertierungs-Transistors über die Sperr-Diode mit dem Referenz-Potential zu koppeln. Mit anderen Worten, nach erfolgreichem Schließen des Konvertierungs-Transistors kann die relativ niederohmige Verbindung des Kontrollports des Konvertierungs-Transistors mit der Schaltspannung durch eine relativ hochomige Verbindung ersetzt werden. Als Folge daraus kann der Energieverbrauch für das "Geschlossenhalten" des Konvertierungs-Transistors reduziert werden.

Nach Ablauf des Messzeitraums (bzw. direkt am Ende des Messzeitraums) kann der zweite Treiber-Transistor angesteuert werden, um den Kontrollport mit dem Referenz-Potential zu koppeln, so dass der Konvertierungs-Transistor geöffnet wird. Der Messpunkt kann dann auf den nächsten Messzeitraum zur Erfassung von Messdaten bezüglich der nachfolgenden Periode der Netzspannung vorbereitet werden (z.B. durch Entladen der ein oder mehreren Mess-Kondensatoren). So kann eine präzise Erfassung von Messdaten in aufeinander folgenden Perioden der Netzspannung ermöglicht werden.

Die Schaltspannung kann größer sein als der Maximalwert der Messspannung. Beispielsweise kann die Schaltspannung bei 12V liegen und der Maximalwert der Messspannung kann bei 5V liegen. Die Schaltspannung kann durch einen Spannungswandler aus der Netzspannung generiert werden. Durch die Verwendung einer gegenüber dem Maximalwert der Messspannung erhöhten Schaltspannung kann ein zuverlässiges Schließen des Konvertierungs-Transistors gewährleistet werden.

Die Steuereinheit kann eingerichtet sein, zur Synchronisation mit der Netzspannung, den Konvertierungs-Transistor an einem Schließzeitpunkt zu schließen, um die von der Netzspannung abhängige Messspannung an dem Messpunkt bereitzustellen. Des Weiteren kann die Steuereinheit eingerichtet sein, ausgehend von dem Schließzeitpunkt Messdaten in Bezug auf einen zeitlichen Verlauf der Messspannung zu erfassen. Außerdem kann die Steuereinheit eingerichtet sein, den Messzeitraum zur Erfassung von Messdaten in Bezug auf den Scheitelpunkt der Netzspannung in Abhängigkeit von den Messdaten in Bezug auf den zeitlichen Verlauf der Messspannung zeitlich zu positionieren. Insbesondere kann ein Zeitpunkt eines Scheitelpunkts des zeitlichen Verlaufs der Messspannung ermittelt werden. Der Messzeitraum zur Erfassung von Messdaten in Bezug auf den Scheitelpunkt der Netzspannung kann dann in Abhängigkeit von dem Zeitpunkt des ermittelten Scheitelpunkts des zeitlichen Verlaufs der Messspannung positioniert werden. So kann in präziser Weise der Messzeitraum zur Ermittlung von Messdaten in Bezug auf den Scheitelpunkt der Netzspannung festgelegt werden.

Alternativ oder ergänzend kann die Steuereinheit eingerichtet sein, zur Synchronisation mit der Netzspannung, in einer Sequenz von Perioden der Netzspannung Messdaten in Bezug auf die Messspannung in unterschiedlichen Phasenabschnitten der Perioden der Netzspannung zu erfassen. Beispielsweise kann eine Periode in R Phasenabschnitte (z.B. R>1, insbesondere R>5, 10, 15) unterteilt werden, die sich ggf. teilweise überschneiden. Es können in einer Sequenz von Perioden Messdaten für die R Phasenabschnitte erfasst werden. Des Weiteren kann auf Basis der Messdaten der Phasenabschnitt selektiert werden, in dem der Scheitelpunkt der Netzspannung liegt. Insbesondere kann der Phasenabschnitt ermittelt werden, in dem der betraglich größte Messwert erfasst wurde. Der Messzeitraum zur Erfassung von Messdaten in Bezug auf den Scheitelpunkt der Netzspannung kann dann in Abhängigkeit von dem selektierten Phasenabschnitt positioniert werden. Insbesondere kann der Messzeitraum derart positioniert werden, dass der selektierte Phasenabschnitt zumindest teilweise in den Messzeitraum fällt. So kann in präziser Weise der Messzeitraum zur Ermittlung von Messdaten in Bezug auf den Scheitelpunkt der Netzspannung festgelegt werden.

Die Schaltanordnung kann unterschiedliche Varianten für unterschiedliche Bereiche von Netzspannungen (z.B. für einen 230V-Bereich bzw. für einen 130V-Bereich) aufweisen. Dabei kann für die unterschiedlichen Varianten der Messpunkt in unterschiedlicher Weise, insbesondere über unterschiedlich dimensionierte Mess-Widerstände, mit dem zumindest einen Messeingang der Steuereinheit gekoppelt sein. Die Mess-Widerstände können dabei derart dimensioniert sein, dass sich für die unterschiedlichen Netzspannungsbereiche ein einheitlicher Messspannungsbereich (z.B. von 0V bis 5V) ergibt. So kann die Schaltanordnung in effizienter Weise an unterschiedliche Netzspannungsbereiche angepasst werden.

Die Netzspannung kann unterschiedliche Netzfrequenzen (z.B. 50Hz bzw. 60Hz) aufweisen. Die Schaltanordnung kann Mittel, insbesondere einen Pullup-Widerstand und/oder einen Pulldown-Widerstand, aufweisen, die der Steuereinheit die Netzfrequenz der Netzspannung anzeigen. Die Steuereinheit kann dann eingerichtet sein, den Konvertierungs-Transistor in Abhängigkeit von der Netzfrequenz der Netzspannung zu steuern. Insbesondere können die Messzeiträume in Abhängigkeit von der Netzspannung positioniert werden, z.B. derart, dass die Messzeiträume in aufeinander folgenden Perioden der Netzspannung jeweils den Scheitelpunkt zumindest einer Halbwelle umfassen. So kann die Schaltanordnung in effizienter Weise an unterschiedliche Netzfrequenzen angepasst werden.

Gemäß einem weiteren Aspekt der Erfindung wird ein elektrisches Gerät, insbesondere ein Hausgerät, beschrieben, dass die in diesem Dokument beschriebene Schaltanordnung umfasst.

Es ist zu beachten, dass jegliche Aspekte der in diesem Dokument beschriebenen Schaltanordnung in vielfältiger Weise miteinander kombiniert werden können. Insbesondere können die Merkmale der Patentansprüche in vielfältiger Weise miteinander kombiniert werden.

Im Weiteren wird die Erfindung anhand von in den beigefügten Zeichnungen dargestellten Ausführungsbeispielen näher beschrieben. Dabei zeigen
- Figur 1: eine beispielhafte Schaltanordnung zur Erfassung der Netzspannung;
- Figur 2: einen beispielhaften zeitlichen Verlauf von positiven Halbwellen der Netzspannung; und
- Figur 3: ein Ablaufdiagramm eines beispielhaften Verfahrens zur Synchronisierung der Erfassung von Messdaten in Bezug auf einen Scheitelwert der Netzspannung.

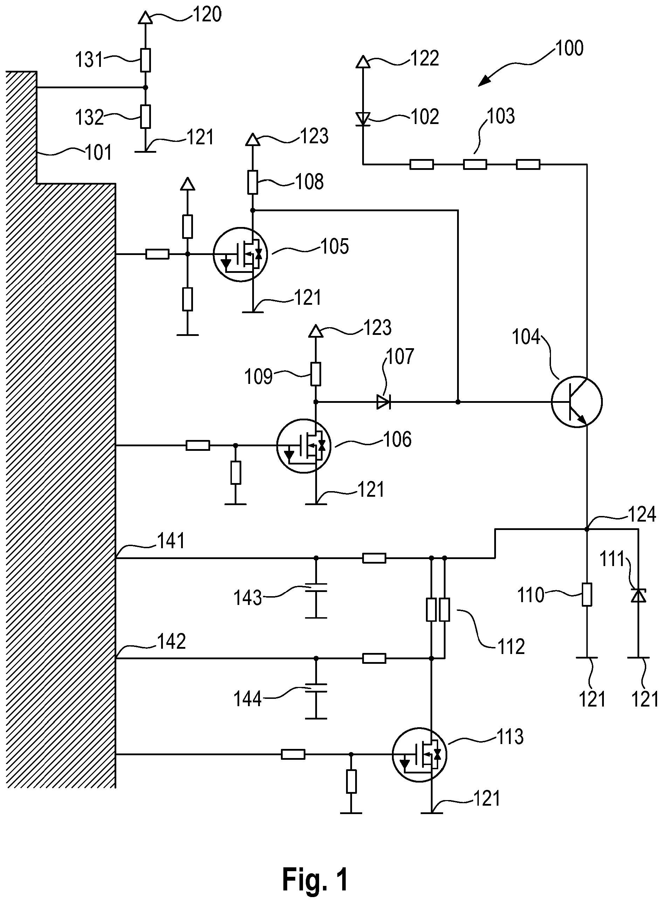

Wie eingangs dargelegt, befasst sich das vorliegende Dokument mit der effizienten und präzisen Messung der Netzspannung, die zum Betrieb eines elektrischen Geräts, insbesondere eines Hausgeräts, bereitgestellt wird. In diesem Zusammenhang zeigt Fig. 1 eine beispielhafte Schaltanordnung 100 zur Erfassung der Netzspannung 122. Die Schaltanordnung 100 kann z.B. in einem elektrischen Gerät dazu verwendet werden, die Netzspannung 122 zu überwachen.

Die Schaltanordnung 100 umfasst eine Steuereinheit 101 (z.B. einen Mikrocontroller), die eingerichtet ist, unterschiedliche Komponenten (insbesondere die Transistoren 104, 105, 106, 113) der Schaltanordnung 100 zu steuern. Des Weiteren kann die Steuereinheit 101 eingerichtet sein, Messdaten in Bezug auf die Netzspannung 122 zu erfassen. Außerdem kann die Steuereinheit 101 eingerichtet sein, das elektrische Gerät in Abhängigkeit von den Messdaten in Bezug auf die Netzspannung 122 in einen sicheren Betriebsmodus zu überführen (z.B. bei Unterschreiten einer unteren Netzspannungsschwelle oder bei Überschreiten einer oberen Netzspannungsschwelle).

Die Schaltanordnung 100 kann Mittel 131, 132 aufweisen, mit denen unterschiedliche Varianten der Schaltanordnung 100 unterschieden werden können. Beispielsweise kann eine 230VAC-Variante bzw. eine EU-Variante für ein 230VAC Versorgungsnetz mit einer Netzfrequenz von 50Hz und eine 130VAC-Variante bzw. eine US-Variante für ein 130VAC Versorgungsnetz mit einer Netzfrequenz von 60Hz bereitgestellt werden. Durch einen Pullup Widerstand 131 kann ein Logikeingang der Steuereinheit 101 mit einer Logikspannung 120 gekoppelt werden. So kann der Steuereinheit 101 z.B. angezeigt werden, dass es sich bei der Schaltanordnung 100 um die 230VAC-Variante handelt. Andererseits kann z.B. ein Pulldown Widerstand 132 dazu verwendet werden, den Logikeingang der Steuereinheit 101 auf ein Referenz-Potential 121 (z.B. Masse bzw. Ground) zu legen und so der Steuereinheit 101 anzuzeigen, dass es sich bei der Schaltanordnung 100 um die 130VAC-Variante handelt.

Die Schaltanordnung 100 umfasst einen Konvertierungs-Transistor 104, der dazu verwendet wird, die Netzspannung 122 (die in der 230VAC-Variante bis 300V hoch sein kann) auf ein reduziertes Messspannungs-Niveau (z.B. bis 5V) zu reduzieren, so dass in zuverlässiger und präziser Weise durch einen Analog-Digital Wandler der Steuereinheit 101 Messdaten in Bezug auf die Netzspannung 122 erfasst werden können. Der Konvertierungs-Transistor 104 kann einen (NPN) Bipolartransistor, insbesondere einen Hochspannungs-Bipolartransistor, umfassen.

Der Konvertierungs-Transistor 104 ist, wie in Fig. 1 dargestellt, zwischen der Netzspannung 122 (z.B. der N-Leitung oder der L-Leistung) und einem Referenz-Potential 121 (z.B. Masse bzw. Ground) angeordnet. Eine Diode 102 (insbesondere eine Schottky-Diode) kann dazu verwendet werden, die Netzspannung 122 gleichzurichten, indem nur die positive Halbwelle der AC-Netzspannung 122 über ein oder mehrere Widerstände 103 an den Emitter des Konvertierungs-Transistors 104 herangeführt wird. Wenn der Konvertierungs-Transistor 104 leitend (d.h. geschlossen) ist, wirkt der Durchlass-Widerstand des Konvertierungs-Transistors 104 im Zusammenspiel mit einem Referenz-Widerstand 110 wie ein Spannungsteiler. Der Mittelpunkt dieses Spannungsteilers kann dann als Messpunkt zur Messung einer Messspannung 124 verwendet werden, wobei die Messspannung 124 proportional zur (positiven Halbwelle der) Netzspannung 122 ist. Die Schaltanordnung 100 umfasst eine Zener-Diode 111, die parallel zu dem Referenz-Widerstand 110 angeordnet ist, um die Messspannung 124 auf einen bestimmten Maximalwert (z.B. 5V) zu begrenzen und um so die ein oder mehreren Messeingänge 141, 142 der Steuereinheit 101 zu schützen.

Die Steuereinheit 101 kann eingerichtet sein, eine Differenzspannung zwischen zwei Messeingängen 141, 142 zu erfassen (z.B. mittels eines Analog-Digital Wandlers). Zu diesem Zweck kann die Schaltanordnung 100 einen Mess-Widerstand 112 aufweisen, der mittels eines Mess-Transistors 113 parallel zu dem Referenz-Widerstand 110 geschaltet werden kann. In Fig. 1 sind unterschiedliche Mess-Widerstände 110 für unterschiedliche Varianten der Schaltanordnung 100 dargestellt. Das Potential an einer ersten Seite des Mess-Widerstands 112 kann über einen ersten Messeingang 141 und das Potential an einer zweiten Seite des Mess-Widerstands 112 kann über einen zweiten Messeingang 142 der Steuereinheit 101 erfasst werden. Insbesondere können so in präziser Weise der Spannungsabfall an dem Mess-Widerstand 112 und damit Messdaten in Bezug auf die Messspannung 124 bzw. in Bezug auf die Netzspannung 122 erfasst werden.

Durch das Schließen des Mess-Transistors 113 kann ein Messzeitraum zur Messung von Messdaten in Bezug auf die Netzspannung 122 begonnen werden. Insbesondere können bei geschlossenem Mess-Transistor 113 der erste Mess-Kondensator 143 entsprechend dem ersten Potential und der zweite Mess-Kondensator 144 entsprechend dem zweiten Potential aufgeladen werden. Die Potentialdifferenz zwischen dem Potential des ersten Mess-Kondensators 143 und dem Potential des zweiten Mess-Kondensators 144 entspricht dann der Messpannung 124 und zeigt somit das Niveau der Netzspannung 122 an. Durch Öffnen des Mess-Transistors 113 kann der Messzeitraum zur Messung von Messdaten in Bezug auf die Netzspannung 122 beendet werden.

Der Konvertierungs-Transistor 104 zum Herabsetzen des Spannungsniveaus der Netzspannung auf ein reduziertes Messspannungs-Niveau kann über ein oder mehreren Treiber-Transistoren 105, 106 angesteuert werden. Insbesondere kann ein erster Treiber-Transistor 106 geöffnet werden, um die Basis des Konvertierungs-Transistors 104 über einen relativ kleinen ersten Treiber-Widerstand 109 mit einer Schaltspannung 123 (z.B. 12V) zu koppeln. Die Verwendung eines relativ kleinen Treiber-Widerstands 109 ermöglicht ein relativ schnelles und stabiles Schließen des Konvertierungs-Transistors 104. Andererseits kann nach dem Schließen des Konvertierungs-Transistors 104 ein zweiter Treiber-Transistor 105 dazu verwendet werden, die Basis des Konvertierungs-Transistors 104 über einen relativ großen zweiten Treiber-Widerstand 108 mit der Schaltspannung 123 zu koppeln. Der erste Treiber-Transistor 106 kann dann geschlossen sein und über die Sperr-Diode 107 von der Basis des Konvertierungs-Transistors 104 entkoppelt sein. So kann der Energieverbrauch zur Ansteuerung des Konvertierungs-Transistors 104 im Anschluss an den Schließvorgang des Konvertierungs-Transistors 104 reduziert werden.

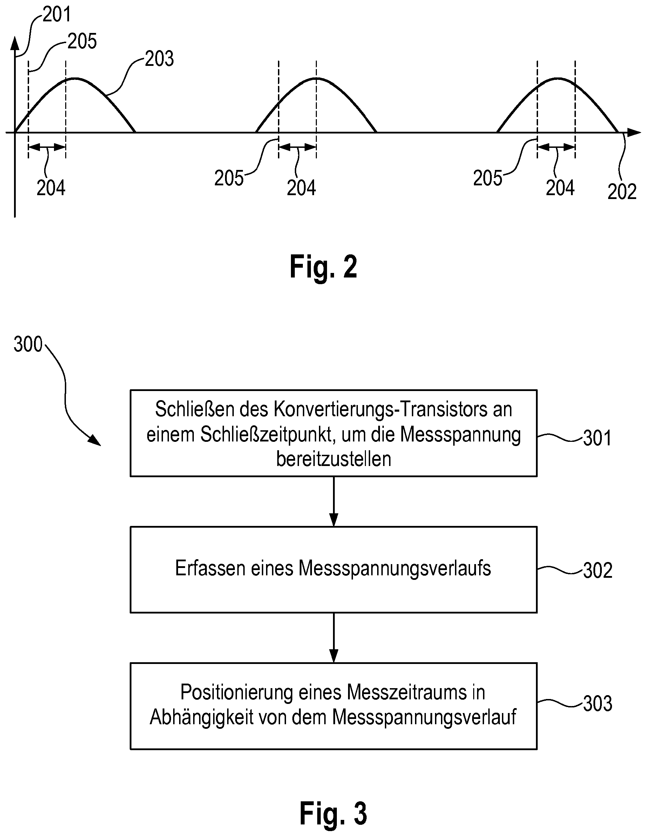

Bei Betriebsbeginn der Schaltanordnung 100 kann zunächst eine Synchronisation mit der Netzspannung 122 erfolgen, wie beispielhaft in Fig. 2 dargestellt. Dabei ist der Steuereinheit 101 über die Widerstände 131, 132 die Netzspannungsversion (z.B. 130V oder 230V) und/oder die Netzfrequenz (z.B. 60Hz oder 50Hz) bekannt. Zu einem beliebigen Schließzeitpunkt 205 werden die ein oder mehreren Treiber-Transistoren 105, 106 angesteuert, um den Konvertierungs-Transistor 104 zu schließen. Als Folge daraus wird eine Messspannung 124 an dem Emitter des Konvertierungs-Transistors 104 bereitgestellt, die proportional zu der gleichgerichteten Netzspannung 203 ist. Es können dann für einen bestimmten Messzeitraum 204 Messdaten bezüglich der Messspannung 124 erfasst werden. Der Messzeitraum 204 kann z.B. eine zeitliche Länge von 500µs aufweisen (bei einer Netzfrequenz von 50Hz). Es kann dann durch die Steuereinheit 101 der Maximalwert der erfassten Spannung in dem Messzeitraum 204 und/oder der Mittelwert der erfassten Spannung in dem Messzeitraum 204 als Messwert für die Netzspannung 122 ermittelt werden.

Der Schließzeitpunkt 205 kann dann für eine folgende Halbwelle der Netzspannung 122 verschoben werden, und es kann ein erneuter Messwert für die Spannung ermittelt werden. So kann in einer Folge von relativ verschobenen Messzeiträumen 204 für eine Folge von Perioden der Netzspannung 122 der ermittelte Messwert für die Netzspannung 122 maximiert werden. Sobald ein maximaler Messwert gefunden wurde, ist eine Synchronisation mit der Netzfrequenz erfolgt, und der Schließzeitpunkt 205 kann daraufhin periodisch (mit der jeweiligen Netzfrequenz) wiederholt werden. So kann gewährleistet werden, dass im Anschluss an eine Synchronisation, Messdaten in Bezug auf den Scheitelwert der Netzspannung 122 erfasst werden können.

Es wird somit eine Schaltung 100 bereitgestellt, die kontinuierlich die Netzspannung 122 in einem definiert zulässigen Bereich überwacht und ggf. bei Unter- oder Überschreitung von vordefinierten Netzspannungsschwellen externe Lasten abschaltet. Dabei können zumindest zwei sich teilweise überlappende Spannungsbereiche definiert sein, insbesondere eine US-Variante (130VAC 60Hz) und eine EU-Variante (230VAC 50Hz). Beide Spannungsbereiche können über einen wahlweise zu bestückenden Mess-Widerstand 112 angesteuert und ausgewertet werden. Die Erkennung der jeweiligen Schaltungs-Variante kann über einen Pullup-Widerstand 131 für die EU-Variante und über einen Pulldown-Widerstand 132 für die US-Variante erfolgen (oder umgekehrt). Anhand der beschriebenen Schaltungsanordnung 100 kann die Netzspannung 122 im Scheitelpunkt gemessen werden.

Die Netzspannung 122 kann z.B. über eine Schottky-Diode 102 gleichgerichtet werden, so dass z.B. nur die positiven Halbwellen der Netzspannung 122 aktiv sind und erfasst werden können. Die Kontroll-Frequenz der Steuereinheit 101 (für die periodische Wiederholung von Messzeiträumen 204) stimmt bevorzugt mit der Netzfrequenz der Netzspannung (z.B. 50Hz oder 60Hz) überein.

Die aktive Messzeit zur Messung des Scheitelwertes der Netzspannung 122 kann z.B. 500µs (Pulsweitenmodulation, PWM) bei einer positiven Halbwelle während des Maximums der Netzspannung 122 betragen.

Die Netzspannung 122 ist, wie in Fig. 1 dargestellt, über eine Diode 102 und Widerständen 103 in Reihe mit dem Kollektor eines Konvertierungs-Transistors 104 (insbesondere eines Hochspannungstransistors) gekoppelt. Der gemeinsame Referenzpegel zwischen einem Analogeingang der Steuereinheit 101 und dem Konvertierungs-Transistor 104 ist der Emitter-Pin des Konvertierungs-Transistors 104. Über einen weiteren Referenz-Widerstand 110 ist der Emitter des Konvertierungs-Transistors 104 mit GND 121 verbunden.

Bei aktiver Netzspannung 122 (d.h. bei einer positiven Halbwelle der Netzspannung 122) wird der Konvertierungs-Transistor 104 durch die Steuereinheit 101 durchgeschaltet. Der Mess-Transistor 122 (z.B. ein MOSFET) in der Messstrecke kann dabei ggf. weiterhin gesperrt bleiben.

Der Spannungspegel am Emitter-Pin des Konvertierungs-Transistors 104 folgt der ansteigenden positiven Halbwelle der Netzspannung 122 und generiert einen Spannungsabfall am Referenz-Widerstand 110. Wenn der Spannungspegel am Emitter die Schaltspannung 123 erreichen würde, würde sich der Konvertierungs-Transistor 104 selbst sperren, da kein Spannungsabfall mehr zwischen der Basis und dem Emitter des Konvertierungs-Transistors 104 vorhanden wäre. Eine derartige Anbindung kann auch als Emitterfolger bezeichnet werden.

Während des gesperrten Zustandes des Konvertierungs-Transistors 104 kann der Spannungspegel im Emitterbereich reduziert werden, bis zum Erreichen einer neuen positiven Halbwelle der Netzspannung 122. Durch die Begrenzung der Schaltspannung 123 und/oder durch die Verwendung einer Zener-Diode 111 kann gewährleistet werden, dass die Messspannung 124 niemals einen bestimmten Spannungspegel (z.B. die Schaltspannung 123) übersteigt, so dass die digitale Logik (d.h. die Steuereinheit 101) vor Zerstörung geschützt ist.

Bei einer Begrenzung der Messspannung 124 auf 5V kann mit der in Fig. 1 dargestellten Schaltanordnung 100 am Emitter des Konvertierungs-Transistors 104 eine relativ weiter Messbereich von 1,6V bis 4,8V zur Messung der Netzspannung 122 bereitgestellt werden. Die Messspannung 124 liegt dabei über einen Mess-Widerstand 122 direkt an ein oder mehreren Analogeingängen 141, 142 der Steuereinheit 101 an. Der Spannungsverlauf der Messspannung 124 kann beobachtet werden (z.B. um den Scheitelpunkt der Netzspannung 122 zu detektieren). Der Spannungswert des Scheitpunktes der Netzspannung 122 kann dann in einer nachfolgenden positiven Halbwelle der Netzspannung 122 exakt bestimmt werden.

Bis zu dem Beginn einer positiven Halbwelle der Netzspannung 122 kann der Konvertierungs-Transistor 104 gesperrt sein. Andererseits kann der Mess-Transistor 113 durchgeschaltet sein, um den Spannungspegel an den ein oder mehreren Messeingängen 141, 142 der Steuereinheit 101 gegen "0" zu reduzieren (z.B. um die Mess-Kondensatoren 143, 144 zu entladen).

Mit Beginn eines Messzeitraums 204 (d.h. an einem Schließzeitpunkt 205) wird der Konvertierungs-Transistor 104 für eine bestimmte Messzeit (z.B. 500µs) durchgeschaltet. Die Synchronisation mit der Netzspannung 122 kann dabei derart erfolgt sein, dass der Schließzeitpunkt 205 im Scheitelpunkt der Netzspannung 122 liegt. Der Spannungswert des Scheitelpunktes der Messspannung 124 kann dann über die ein oder mehreren Messeingänge 141, 142 der Steuereinheit 101 eingelesen werden.

Fig. 3 zeigt ein Ablaufdiagramm eines beispielhaften Verfahrens 300 zur Synchronisation der Schaltanordnung 100 mit der Netzspannung 122, um in präziser Weise Messdaten in Bezug auf den Scheitelpunkt der Netzspannung 122 zu erfassen. Das Verfahren 300 umfasst das Schließen 301 des Konvertierungs-Transistors 104 an einem Schließzeitpunkt 205, um eine von der Netzspannung 122 abhängige Messspannung 124 an dem Messpunkt zwischen dem Konvertierungs-Transistor 104 und dem Referenz-Widerstand 110 bereitzustellen. Außerdem umfasst das Verfahren 300 das Erfassen 302 von Messdaten in Bezug auf den zeitlichen Verlauf der Messspannung 124. Die Messdaten können dabei an den ein oder mehreren Messeingängen 141, 142 der Steuereinheit 101 erfasst werden. Außerdem umfasst das Verfahren 300 das Positionieren 303 des Messzeitraums 204 zur Erfassung von Messdaten in Bezug auf den Scheitelpunkt der Netzspannung 122 (insbesondere das Anpassen eines Schließzeitpunkts 205 für den Beginn des Messzeitraums 204), in Abhängigkeit von den Messdaten in Bezug auf den zeitlichen Verlauf der Messspannung 124. Insbesondere kann der Messzeitraum 204 in Abhängigkeit von dem Zeitpunkt eines Scheitelpunktes des zeitlichen Verlaufs der Messspannung 124 positioniert werden. So kann in zuverlässiger Weise eine Synchronisation mit der (periodischen) Netzspannung 124 bewirkt werden.

Durch die in diesem Dokument beschriebene Schaltanordnung 100 kann der Maximalwert der Netzspannung 122 in präziser Weise über einen relativ weiten Messbereich erfasst werden. Dabei wird ein besonders stabiler Betrieb der Schaltanordnung 100 ermöglicht, wenn eine gegenüber der maximalen Messspannung 124 (z.B. 5V) erhöhte Schaltspannung 123 (z.B. 12V) zur Ansteuerung des Konvertierungs-Transistors 104 verwendet wird.

Die vorliegende Erfindung ist nicht auf die gezeigten Ausführungsbeispiele beschränkt. Insbesondere ist zu beachten, dass die Beschreibung und die Figuren nur das Prinzip der vorgeschlagenen Schaltanordnung veranschaulichen sollen.

## Patentansprüche

1. Schaltanordnung (100) zur Ermittlung von Messdaten in Bezug auf eine Netzspannung (122) eines elektrischen Geräts; wobei die Schaltanordnung (100) umfasst,
- einen Konvertierungs-Transistor (104) und einen Referenz-Widerstand (110), die in Reihe zwischen der Netzspannung (122) und einem Referenz-Potential (121) angeordnet sind, so dass an einem Messpunkt zwischen dem Konvertierungs-Transistor (104) und dem Referenz-Widerstand (110) eine von der Netzspannung (122) abhängige Messspannung (124) bereitgestellt wird, wenn der Konvertierungs-Transistor (104) zumindest teilweise geschlossen ist; und
- eine Steuereinheit (101) mit zumindest einem Messeingang (141, 142); wobei der zumindest eine Messeingang (141, 142) mit dem Messpunkt gekoppelt ist, so dass durch die Steuereinheit (101) Messdaten in Bezug auf die Messspannung (124) erfasst werden können; wobei die Steuereinheit (101) eingerichtet ist,
- auf Basis der Messdaten einen Messzeitraum (204) zur Messung von Messdaten in Bezug auf einen Scheitelpunkt der Netzspannung (122) zu bestimmen; und
- den Konvertierungs-Transistor (104) in Abhängigkeit von dem Messzeitraum (204) anzusteuern, um über den zumindest einen Messeingang (141, 142) Messdaten in Bezug auf den Scheitelpunkt der Netzspannung (122) zu erfassen
- wobei die Schaltanordnung (100) einen Mess-Widerstand (112) und einen Mess-Transistor (113) umfasst, die in Reihe zwischen dem Messpunkt und dem Referenz-Potential (121) angeordnet sind;
- eine erste Seite des Mess-Widerstands (112) mit dem Messpunkt gekoppelt ist;
- eine zweite Seite des Mess-Widerstands (112) mit dem Mess-Transistor (113) gekoppelt ist; und
- die Steuereinheit (101) einen ersten Messeingang (141) umfasst, der mit der ersten Seite des Mess-Widerstands (112) gekoppelt ist, und einen zweiten Messeingang (142) umfasst, der mit der zweiten Seite des Mess-Widerstands (112) gekoppelt ist.

2. Schaltanordnung (100) gemäß Anspruch 21, wobei die Steuereinheit (101) eingerichtet ist,
- den Mess-Transistor (113) vor einem Beginn des Messzeitraums (204) zu schließen; und/oder
- den Mess-Transistor (113) am Ende des Messzeitraums (204) zu öffnen.

3. Schaltanordnung (100) gemäß einem der vorhergehenden Ansprüche, wobei der Messpunkt über zumindest ein Tiefpassfilter (143, 144), insbesondere über zumindest ein RC-Glied, mit dem zumindest einen Messeingang (141, 142) der Steuereinheit (101) gekoppelt ist.

4. Schaltanordnung (100) gemäß einem der vorhergehenden Ansprüche, wobei die Schaltanordnung (100) zumindest eine Diode (102) umfasst, die in Reihe mit dem Konvertierungs-Transistor (104) und dem Referenz-Widerstand (110) zwischen der Netzspannung (122) und dem Referenz-Potential (121) angeordnet ist, so dass an dem Konvertierungs-Transistor (104) jeweils nur Halbwellen (203) der Netzspannung (122) mit einer ersten Polarität relativ zu dem Referenz-Potential (121) anliegen.

5. Schaltanordnung (100) gemäß einem der vorhergehenden Ansprüche, wobei die Schaltanordnung (100) Mittel (111), insbesondere eine Zener-Diode, umfasst, um die Messspannung (124) an dem Messpunkt auf einen bestimmten Maximalwert zu begrenzen.

6. Schaltanordnung (100) gemäß einem der vorhergehenden Ansprüche, wobei
- die Schaltanordnung (100) einen ersten Treiber-Transistor (106) umfasst, der angeordnet ist, einen Kontrollport des Konvertierungs-Transistors (104) über einen ersten Treiber-Widerstand (109) mit einer Schaltspannung (123) zu koppeln;
- die Schaltanordnung (100) einen zweiten Treiber-Transistor (105) umfasst, der angeordnet ist, den Kontrollport des Konvertierungs-Transistors (104) über einen zweiten Treiber-Widerstand (108) mit der Schaltspannung (123) zu koppeln; und
- die Steuereinheit (101) eingerichtet ist, den ersten Treiber-Transistor (106) und/oder den zweiten Treiber-Transistor (105) anzusteuern, um den Konvertierungs-Transistor (104) zu schließen und/oder geschlossen zu halten.

7. Schaltanordnung (100) gemäß Anspruch 76, wobei
- der erste Treiber-Widerstand (109) einen kleineren Widerstandswert aufweist als der zweite Treiber-Widerstand (108);
- der erste Treiber-Transistor (106) angeordnet ist, den Kontrollport des Konvertierungs-Transistors (104) über eine Sperr-Diode (107) mit dem Referenz-Potential (121) zu koppeln;
- die Sperr-Diode (107) in einer Richtung von dem Kontrollport zum Referenz-Potential (121) sperrt; und
- die Steuereinheit (101) eingerichtet ist,
- zu Beginn des Messzeitraums (204) den ersten Treiber-Transistor (106) anzusteuern, um den Konvertierungs-Transistor (104) zu schließen;
- nach Schließen des Konvertierungs-Transistors (104) den zweiten Treiber-Transistor (105) anzusteuern, um den Konvertierungs-Transistor (104) geschlossen zu halten; und/oder
- nach Schließen des Konvertierungs-Transistors (104) den ersten Treiber-Transistor (106) anzusteuern, den Kontrollport des Konvertierungs-Transistors (104) über die Sperr-Diode (107) mit dem Referenz-Potential (121) zu koppeln.

8. Schaltanordnung (100) gemäß einem der vorhergehenden Ansprüche, wobei die Steuereinheit (101) eingerichtet ist, zur Synchronisation mit der Netzspannung (122),
- den Konvertierungs-Transistor (104) an einem Schließzeitpunkt (205) zu schließen, um eine von der Netzspannung (122) abhängige Messspannung (124) an dem Messpunkt bereitzustellen;
- ausgehend von dem Schließzeitpunkt (205) Messdaten in Bezug auf einen zeitlichen Verlauf der Messspannung (124) zu erfassen; und
- den den Messzeitraum (204) zur Erfassung von Messdaten in Bezug auf den Scheitelpunkt der Netzspannung (122) in Abhängigkeit von den Messdaten in Bezug auf den zeitlichen Verlauf der Messspannung (124) zeitlich zu positionieren, insbesondere in Abhängigkeit von einem Zeitpunkt eines Scheitelpunkts des zeitlichen Verlaufs der Messspannung (124).

9. Schaltanordnung (100) gemäß einem der vorhergehenden Ansprüche, wobei die Steuereinheit (101) eingerichtet ist, zur Synchronisation mit der Netzspannung (122),
- in einer Sequenz von Perioden der Netzspannung (122) Messdaten in Bezug auf die Messspannung (124) in unterschiedlichen Phasenabschnitten der Perioden der Netzspannung (122) zu erfassen;
- auf Basis der Messdaten den Phasenabschnitt zu selektieren, in dem der Scheitelpunkt der Netzspannung (122) liegt; und
- den Messzeitraum (204) zur Erfassung von Messdaten in Bezug auf den Scheitelpunkt der Netzspannung (122) in Abhängigkeit von dem selektierten Phasenabschnitt zu positionieren.

10. Schaltanordnung (100) gemäß einem der vorhergehenden Ansprüche, wobei
- die Netzspannung (122) eine Netzfrequenz aufweist; und
- die Steuereinheit (101) eingerichtet ist, Messzeiträume (204) zur Erfassung von Messdaten in Bezug auf den Scheitelpunkt der Netzspannung (122) in Abhängigkeit von der Netzfrequenz zu wiederholen.

11. Schaltanordnung (100) gemäß einem der vorhergehenden Ansprüche, wobei der Messzeitraum (204) eine Zeitdauer aufweist, die 20%, 15%, 10% oder weniger einer Periodendauer der Netzspannung (122) entspricht.

12. Schaltanordnung (100) gemäß einem der vorhergehenden Ansprüche, wobei
- die Schaltanordnung (100) unterschiedliche Varianten für unterschiedliche Bereiche von Netzspannungen (122) aufweist; und
- für die unterschiedlichen Varianten der Messpunkt in unterschiedlicher Weise, insbesondere über unterschiedlich dimensionierte Mess-Widerstände (112), mit dem zumindest einen Messeingang (141, 142) der Steuereinheit (101) gekoppelt ist.

13. Schaltanordnung (100) gemäß einem der vorhergehenden Ansprüche, wobei
- die Netzspannung (122) unterschiedliche Netzspannungsversionen und/oder Netzfrequenzen aufweisen kann;
- die Schaltanordnung (100) Mittel (131, 132), insbesondere einen Pullup-Widerstand (131) und/oder einen Pulldown-Widerstand (132), aufweist, die der Steuereinheit (101) die Netzspannungsversion und/oder die Netzfrequenz der Netzspannung (122) anzeigen; und
- die Steuereinheit (101) eingerichtet ist, den Konvertierungs-Transistor (104) in Abhängigkeit von der Netzfrequenz der Netzspannung (122) zu steuern.

14. Schaltanordnung (100) gemäß einem der vorhergehenden Ansprüche, wobei der Konvertierungs-Transistor (104) einen Bipolartransistor, insbesondere einen NPN Bipolartransistor, umfasst.

## Claims

1. Switching arrangement (100) for ascertaining measurement data relating to a network voltage (122) of an electrical device; wherein the switching arrangement (100) comprises
- a conversion transistor (104) and a reference resistor (110), which are arranged in series between the network voltage (122) and a reference potential (121), so that a measurement voltage (124), which is dependent upon the network voltage (122), is provided at a measuring point between the conversion transistor (104) and the reference resistor (110) when the conversion transistor (104) is at least partially closed; and
- a control unit (101) with at least one measurement input (141, 142); wherein the at least one measurement input (141, 142) is coupled to the measuring point, so that measurement data relating to the measurement voltage (124) can be captured by the control unit (101); wherein the control unit (101) is configured
- to determine a measurement time period (204) for measuring measurement data relating to a peak of the network voltage (122) on the basis of the measurement data; and
- to actuate the conversion transistor (104) as a function of the measurement time period (204), in order to capture measurement data relating to the peak of the network voltage (122) via the at least one measurement input (141, 142)
- wherein the switching arrangement (100) comprises a measurement resistor (112) and a measurement transistor (113), which are arranged in series between the measuring point and the reference potential (121);
- a first side of the measurement resistor (112) is coupled to the measuring point;
- a second side of the measurement resistor (112) is coupled to the measurement transistor (113); and
- the control unit (101) comprises a first measurement input (141), which is coupled to the first side of the measurement resistor (112), and a second measurement input (142), which is coupled to the second side of the measurement resistor (112).

2. Switching arrangement (100) according to claim 1, wherein the control unit (101) is configured
- to close the measurement transistor (113) before a beginning of the measurement time period (204); and/or
- to open the measurement transistor (113) at the end of the measurement time period (204).

3. Switching arrangement (100) according to one of the preceding claims, wherein the measuring point is coupled to the at least one measuring input (141, 142) of the control unit (101) via at least one low-pass filter (143, 144), in particular via at least one RC element.

4. Switching arrangement (100) according to one of the preceding claims, wherein the switching arrangement (100) comprises at least one diode (102), which is arranged in series with the conversion transistor (104) and the reference resistor (110) between the network voltage (122) and the reference potential (121), so that in each case only half waves (203) of the network voltage (122) with a first polarity relative to the reference potential (121) are applied to the conversion transistor (104).

5. Switching arrangement (100) according to one of the preceding claims, wherein the switching arrangement (100) comprises means (111), in particular a Zener diode, in order to restrict the measurement voltage (124) at the measuring point to a certain maximum value.

6. Switching arrangement (100) according to one of the preceding claims, wherein
- the switching arrangement (100) comprises a first driver transistor (106), which is arranged to couple a control port of the conversion transistor (104) to a switching voltage (123) via a first driver resistor (109);
- the switching arrangement (100) comprises a second driver transistor (105), which is arranged to couple the control port of the conversion transistor (104) to the switching voltage (123) via a second driver resistor (108); and
- the control unit (101) is configured to actuate the first driver transistor (106) and/or the second driver transistor (105), in order to close the conversion transistor (104) and/or keep it closed.

7. Switching arrangement (100) according to claim 6, wherein
- the first driver resistor (109) has a smaller resistance value than the second driver resistor (108);
- the first driver transistor (106) is arranged to couple the control port of the conversion transistor (104) to the reference potential (121) via a blocking diode (107);
- the blocking diode (107) blocks in a direction from the control port to the reference potential (121); and
- the control unit (101) is configured
- to actuate the first driver transistor (106) at the beginning of the measurement time period (204), in order to close the conversion transistor (104);
- to actuate the second driver transistor (105) after closing the conversion transistor (104), in order to keep the conversion transistor (104) closed; and/or
- to actuate the first driver transistor (106) to couple the control port of the conversion transistor (104) to the reference potential (121) via the blocking diode (107), after closing the conversion transistor (104).

8. Switching arrangement (100) according to one of the preceding claims, wherein the control unit (101) is configured, for synchronisation with the network voltage (122),
- to close the conversion transistor (104) at a closing time point (205), in order to provide a measurement voltage (124), which is dependent upon the network voltage (122), at the measuring point;
- starting from the closing time point (205), to capture measurement data relating to a temporal progression of the measurement voltage (124); and
- to temporally position the measurement time period (204) for capturing measurement data relating to the peak of the network voltage (122) as a function of the measurement data relating to the temporal progression of the measurement voltage (124), in particular as a function of a time point of a peak of the temporal progression of the measurement voltage (124).

9. Switching arrangement (100) according to one of the preceding claims, wherein the control unit (101) is configured, for synchronisation with the network voltage (122),
- in a sequence of periods of the network voltage (122), to capture measurement data relating to the measurement voltage (124) in different phase sections of the periods of the network voltage (122);
- to select the phase section, in which the peak of the network voltage (122) lies, on the basis of the measurement data; and
- to position the measurement time period (204) for capturing measurement data relating to the peak of the network voltage (122) as a function of the selected phase section.

10. Switching arrangement (100) according to one of the preceding claims, wherein
- the network voltage (122) has a network frequency; and
- the control unit (101) is configured to repeat measurement time periods (204) for capturing measurement data relating to the peak of the network voltage (122) as a function of the network frequency.

11. Switching arrangement (100) according to one of the preceding claims, wherein the measurement time period (204) has a time duration that corresponds to 20%, 15%, 10% or less than a periodic time of the network voltage (122).

12. Switching arrangement (100) according to one of the preceding claims, wherein
- the switching arrangement (100) has different variants for different regions of network voltages (122); and
- for the different variants, the measuring point is coupled to the at least one measurement input (141, 142) of the control unit (101) in different manners, in particular via measurement resistors (112) with different dimensions.

13. Switching arrangement (100) according to one of the preceding claims, wherein
- the network voltage (122) may have different network voltage versions and/or network frequencies;
- the switching arrangement (100) has means (131, 132), in particular a pull-up resistor (131) and/or a pull-down resistor (132), which indicate the network voltage version and/or the network frequency of the network voltage (122) to the control unit (101); and
- the control unit (101) is configured to control the conversion transistor (104) as a function of the network frequency of the network voltage (122).

14. Switching arrangement (100) according to one of the preceding claims, wherein the conversion transistor (104) comprises a bipolar transistor, in particular an NPN bipolar transistor.

## Revendications

1. Dispositif de commutation (100) permettant de déterminer des données de mesure concernant une tension de réseau (122) d'un appareil électrique ; dans lequel le dispositif de commutation (100) comprend,
- un transistor de conversion (104) et une résistance de référence (110) qui sont disposés en série entre la tension de réseau (122) et un potentiel de référence (121), de sorte qu'au niveau d'un point de mesure entre le transistor de conversion (104) et la résistance de référence (110) une tension de mesure (124) dépendante de la tension de réseau (122) est mise à disposition lorsque le transistor de conversion (104) est fermé au moins partiellement ; et
- une unité de commande (101) avec au moins une entrée de mesure (141, 142) ; dans lequel l'au moins une entrée de mesure (141, 142) est couplée au point de mesure de sorte que par le biais de l'unité de commande (101) des données de mesure concernant la tension de mesure (124) peuvent être détectées ; dans lequel l'unité de commande (101) est configurée pour,
- déterminer sur la base des données de mesure une période de mesure (204) permettant de mesurer des données de mesure concernant une crête de la tension de réseau (122) ; et
- commander le transistor de conversion (104) en fonction de la période de mesure (204) pour détecter des données de mesure concernant la crête de la tension de réseau (122) par l'intermédiaire de l'au moins une entrée de mesure (141, 142),
- dans lequel le dispositif de commutation (100) comprend une résistance de mesure (112) et un transistor de mesure (113) qui sont disposés en série entre le point de mesure et le potentiel de référence (121) ;
- un premier côté de la résistance de mesure (112) est couplé au point de mesure ;
- un second côté de la résistance de mesure (112) est couplé au transistor de mesure (113) ; et
- l'unité de commande (101) comprend une première entrée de mesure (141) qui est couplée au premier côté de la résistance de mesure (112) et comprend une seconde entrée de mesure (142) qui est couplée au second côté de la résistance de mesure (112).

2. Dispositif de commutation (100) selon la revendication 1, dans lequel l'unité de commande (101) est configurée
- pour fermer le transistor de mesure (113) avant un début de la période de mesure (204) ; et/ou
- pour ouvrir le transistor de mesure (113) à la fin de la période de mesure (204).

3. Dispositif de commutation (100) selon l'une quelconque des revendications précédentes, dans lequel le point de mesure est couplé à l'au moins une entrée de mesure (141, 142) de l'unité de commande (101) par l'intermédiaire d'au moins un filtre passe-bas (143, 144), en particulier par l'intermédiaire d'au moins un élément RC.

4. Dispositif de commutation (100) selon l'une quelconque des revendications précédentes, dans lequel le dispositif de commutation (100) comprend au moins une diode (102) qui est disposée en série avec le transistor de conversion (104) et la résistance de référence (110) entre la tension de réseau (122) et le potentiel de référence (121) de sorte qu'au niveau du transistor de conversion (104) ne se trouvent respectivement que des demi-ondes (203) de la tension de réseau (122) avec une première polarité par rapport au potentiel de référence (121).

5. Dispositif de commutation (100) selon l'une quelconque des revendications précédentes, dans lequel le dispositif de commutation (100) comprend des moyens (111), en particulier une diode Zener, pour limiter la tension de mesure (124) à une valeur maximale déterminée au niveau du point de mesure.

6. Dispositif de commutation (100) selon l'une quelconque des revendications précédentes, dans lequel
- le dispositif de commutation (100) comprend un premier transistor de circuit d'attaque (106) qui est agencé pour coupler un port de contrôle du transistor de conversion (104) à une tension de commutation (123) par l'intermédiaire d'une première résistance de circuit d'attaque (109) ;
- le dispositif de commutation (100) comprend un second transistor de circuit d'attaque (105) qui est disposé pour coupler le port de contrôle du transistor de conversion (104) à la tension de commutation (123) par l'intermédiaire d'une seconde résistance de circuit d'attaque (108) ; et
- l'unité de commande (101) est configurée pour commander le premier transistor de circuit d'attaque (106) et/ou le second transistor de circuit d'attaque (105) pour fermer et/ou maintenir fermé le transistor de conversion (104).

7. Dispositif de commutation (100) selon la revendication 6, dans lequel
- la première résistance de circuit d'attaque (109) présente une valeur de résistance plus petite que la seconde résistance de circuit d'attaque (108) ;
- le premier transistor de circuit d'attaque (106) est disposé pour coupler le port de contrôle du transistor de conversion (104) au potentiel de référence (121) par l'intermédiaire d'une diode de blocage (107) ;
- la diode de blocage (107) effectue un blocage dans une direction du port de contrôle au potentiel de référence (121) ; et
- l'unité de commande (101) est configurée
- au début de la période de mesure (204) pour commander le premier transistor de circuit d'attaque (106) pour fermer le transistor de conversion (104) ;
- après la fermeture du transistor de conversion (104) pour commander le second transistor de circuit d'attaque (105) pour maintenir fermé le transistor de conversion (104) ; et/ou
- après la fermeture du transistor de conversion (104) commander le premier transistor de circuit d'attaque (106) pour coupler le port de contrôle du transistor de conversion (104) au potentiel de référence (121) par l'intermédiaire de la diode de blocage (107).

8. Dispositif de commutation (100) selon l'une quelconque des revendications précédentes, dans lequel l'unité de commande (101) est configurée, pour une synchronisation avec la tension de réseau (122), pour
- fermer le transistor de conversion (104) à un moment de fermeture (205) pour mettre à disposition une tension de mesure (124) dépendante de la tension de réseau (122) au niveau du point de mesure ;
- détecter à partir du moment de fermeture (205) des données de mesure concernant une évolution dans le temps de la tension de mesure (124) ; et
- positionner dans le temps le moment de mesure (204) permettant la détection de données de mesure concernant la crête de la tension de réseau (122) en fonction des données de mesure concernant l'évolution dans le temps de la tension de mesure (124), en particulier en fonction d'un moment d'une crête de l'évolution dans le temps de la tension de mesure (124).

9. Dispositif de commutation (100) selon l'une quelconque des revendications précédentes, dans lequel l'unité de commande (101) est configurée, pour une synchronisation avec la tension de réseau (122), pour
- détecter dans une séquence de périodes de la tension de réseau (122) des données de mesure concernant la tension de mesure (124) dans des segments de phase différents des périodes de la tension de réseau (122) ;
- sélectionner sur la base des données de mesure le segment de phase dans lequel se trouve la crête de la tension de réseau (122) ; et
- positionner le moment de mesure (204) permettant la détection de données de mesure concernant la crête de la tension de réseau (122) en fonction du segment de phase sélectionné.

10. Dispositif de commutation (100) selon l'une quelconque des revendications précédentes, dans lequel
- la tension de réseau (122) présente une fréquence de réseau ; et
- l'unité de commande (101) est configurée pour répéter des instants de mesure (204) permettant la détection de données de mesure concernant la crête de la tension de réseau (122) en fonction de la fréquence de réseau.

11. Dispositif de commutation (100) selon l'une quelconque des revendications précédentes, dans lequel l'instant de mesure (204) présente une durée qui correspond à 20 %, 15 %, 10 % ou moins d'une durée de période de la tension de réseau (122).

12. Dispositif de commutation (100) selon l'une quelconque des revendications précédentes, dans lequel
- le dispositif de commutation (100) présente des variantes différentes pour des zones différentes de tensions de réseau (122) ; et
- pour les variantes différentes le point de mesure est couplé différemment, en particulier par l'intermédiaire de résistances de mesure (112) de dimensions différentes, à l'au moins une entrée de mesure (141, 142) de l'unité de commande (101).

13. Dispositif de commutation (100) selon l'une quelconque des revendications précédentes, dans lequel
- la tension de réseau peut présenter des versions de tension de réseau (122) et/ou des fréquences de réseau différentes ;
- le dispositif de commutation (100) présente des moyens (131, 132), en particulier une résistance de tirage (131) et/ou une résistance de rappel (132) qui indiquent la version de tension de réseau et/ou la fréquence de réseau de la tension de réseau (122) à l'unité de commande (101) ; et
- l'unité de commande (101) est configurée pour commander le transistor de conversion (104) en fonction de la fréquence de réseau de la tension de réseau (122).

14. Dispositif de commutation (100) selon l'une quelconque des revendications précédentes, dans lequel le transistor de conversion (104) comprend un transistor bipolaire, en particulier un transistor bipolaire NPN.
